# EUROPEAN PATENT APPLICATION

(11) **EP 4 811 347 A1**
(43) Date of publication of application: **23.09.2026**
(21) Application number: 26166048.4
(22) Date of filing: 19.03.2026
(51) Int. Cl.: G09G 3/34, G09G 3/36

(54) **DISPLAY DEVICE AND DRIVING METHOD THEREOF**

(30) Priority: 19.03.2025 US 202563774111 P
(71) Applicant: E Ink Holdings Inc., 30078 Hsinchu (TW)
(72) Inventor: WU, Chi-Liang, Hsinchu (TW); CHEN, Wei-Tsung, Hsinchu (TW); KUO, Chia-Hao, Hsinchu (TW); CHANG, Chun Kai, Hsinchu (TW)
(74) Representative: Becker, Eberhard

(57) **Abstract**

A display device and a driving method thereof are provided. The display device includes a pixel array. The pixel array includes pixel units. Each of the plurality of pixel units includes a first transistor, a bootstrap capacitor, a second transistor, and a storage capacitor. A first terminal of the first transistor is coupled to a first node. A second terminal of the first transistor is coupled to a reference voltage terminal. A control terminal of the first transistor is coupled to a first gate signal line. A first terminal of the bootstrap capacitor is coupled to the first node. A second terminal of the bootstrap capacitor is coupled to a second gate signal line. A control terminal of the second transistor is coupled to the first node. A first terminal of the second transistor is coupled to a second node. The storage capacitor is coupled to the second node.

## Description

### BACKGROUND

### Technical Field

The disclosure relates to a technology of a display technology, and particularly relates to a display device and a driving method thereof.

### Description of Related Art

Compared to other display technologies (such as LED, OLED), electronic paper related display technologies require stronger electric fields to drive display units (such as microcapsules, cholesteric liquid crystals, etc.) to perform accurate and rapid displacement. The pixel circuit or drive system needs to be able to provide higher data signals (data voltages) and gate drive signals (gate voltages) to corresponding terminals to generate the required electric field. When writing data signals (data voltages), the gate drive signal (gate voltage) needs to be greater than the data voltage to write the data signal into the pixel circuit for driving the display unit. On the other hand, current electronic devices all hope to save power, so the system voltage provided by electronic devices is often lower than the gate voltage. For this, it is usually necessary to additionally have a drive system that can convert low voltage to high voltage, resulting in increased system cost.

### SUMMARY

The disclosure provides a display device and a driving method thereof, having good display driving capability.

The display device of the present invention includes a pixel array. The pixel array includes a plurality of pixel units. Each of the plurality of pixel units includes a first transistor, a bootstrap capacitor, a second transistor, and a storage capacitor. A first terminal of the first transistor coupled to a first node, a second terminal of the first transistor is coupled to a reference voltage terminal, a control terminal of the first transistor is coupled to a first gate signal line, and the first gate signal line is configured to transmit a first gate drive signal. A first terminal of the bootstrap capacitor is coupled to the first node, a second terminal of the bootstrap capacitor is coupled to a second gate signal line, and the second gate signal line is configured to transmit a second gate drive signal. A control terminal of the second transistor is coupled to the first node, a first terminal of the second transistor is coupled to a second node, and a second terminal of the second transistor is coupled to a data signal line to receive a data signal. The storage capacitor is coupled to the second node. A first terminal of the storage capacitor is coupled to the second node, and a second terminal of the storage capacitor is coupled to the reference voltage terminal.

The present invention also provides a driving method for a display device. The display device includes a plurality of pixel units, each of the plurality of pixel units includes a first transistor, a bootstrap capacitor, a second transistor, and a storage capacitor, a first terminal of the first transistor is coupled to a first node, a second terminal of the first transistor is coupled to a reference voltage terminal, and a control terminal of the first transistor is coupled to a first gate signal line, a first terminal of the bootstrap capacitor is coupled to the first node and a second terminal of the bootstrap capacitor is coupled to a second gate signal line, a control terminal of the second transistor is coupled to the first node and a first terminal of the second transistor is coupled to a second node, and the storage capacitor is coupled to the second node, wherein a first gate drive signal is transmitted through the first gate signal line and a second gate drive signal is transmitted through the second gate signal line, the first gate drive signal has a first enable period and a second enable period, and the second gate drive signal has a third enable period. The driving method comprises: during the first enable period of the first gate drive signal, the first transistor is in a conduction state and the second transistor is in a turn-off state, and a gate voltage at the first node is a reference voltage of the reference voltage terminal; during a second period located within the third enable period of the second gate drive signal and before the second enable period of the first gate drive signal, the first transistor is in the turn-off state, and the gate voltage at the first node is boosted from the reference voltage by a preset voltage value via the bootstrap capacitor, wherein the preset voltage value is a voltage difference between a low voltage level and a high voltage level of the second gate drive signal, and, the second transistor is in the conduction state to guide a data signal on the second terminal of the second transistor to the second node; during the second enable period of the first gate drive signal, the first transistor is in the conduction state and the second transistor is in the turn-off state, and the gate voltage of the first node is the reference voltage; and, at a disable time point after the second enable period of the first gate drive signal and the third enable period of the second gate drive signal, the second gate drive signal is reduced from the high voltage level to the low voltage level, and the gate voltage at the first node is reduced from the reference voltage to the low voltage level via the bootstrap capacitor.

Based on the above, the display device and driving method thereof of each embodiment of the present invention is based on the bootstrap capacitor of each pixel unit, and utilizes the gate drive signal (the gate voltage) between approximately -30 volt (V) to +20V to make the voltage of the control terminal reach -30V to +50V, thereby boosting the voltage of the control terminal in the active matrix switch (e.g., thin film transistor), effectively utilizing the boosted gate voltage to write the data signal into the display unit of the pixel circuit, enabling the display device to reduce cost without additionally disposing a driving system. In other words, the voltage specification of the gate driver integrated circuit may be reduced from the conventional approximately 80 volts to approximately 50 volts. Moreover, the active matrix switch (e.g., thin film transistor) of each pixel unit of the embodiments of the present invention may stably maintain its control terminal at the low voltage level when not writing the data signal, making each pixel unit have high stability.

### BRIEF DESCRIPTION OF THE DRAWINGS

Aspects of the present disclosure are best understood from the following detailed description when read with the accompanying figures. It is noted that, in accordance with the standard practice in the industry, various features are not drawn to scale. In fact, the dimensions of the various features may be arbitrarily increased or reduced for clarity of discussion.
FIG. 1 is a schematic diagram of a display device according to an embodiment of the present invention.
FIG. 2 is a schematic diagram of a pixel circuit according to an embodiment of the present invention.
FIG. 3 is a timing diagram of multiple signals and voltages in the embodiment of the present invention in FIG. 2.
FIG. 4 is a detailed schematic diagram of a gate driver circuit in a display device according to an embodiment of the present invention.
FIG. 5 is a schematic diagram of signals in the gate driver circuit of FIG. 4.
FIG. 6 and FIG. 7 are schematic diagrams of driving processes of scan lines in a display device according to an embodiment of the present invention.
FIG. 8 is a flowchart of a driving method of a display device according to an embodiment of the present invention.
FIG. 9 is a schematic diagram of a pixel circuit according to a second embodiment of the present invention.
FIG. 10 is a timing diagram of multiple signals and voltages in the pixel circuit of FIG. 9.
FIG. 11 is a schematic diagram of a display device according to a first sub embodiment in the second embodiment of the present invention.
FIG. 12 is a schematic diagram of multiple signals in FIG. 11.
FIG. 13 is a schematic diagram of a display device according to a second sub embodiment in the second embodiment of the present invention.
FIG. 14 is a schematic diagram of a display device according to a third sub embodiment in the second embodiment of the present invention.
FIG. 15 is a flowchart of a driving method of a display device according to a second embodiment of the present invention.
FIG. 16 is a schematic diagram of a pixel circuit according to a third embodiment of the present invention.
FIG. 17 is a timing diagram of multiple signals and voltages in the pixel circuit of FIG. 16.
FIG. 18 is a timing diagram of multiple signals and voltages for adjacent rows of pixel units in the pixel circuit of FIG. 16.
FIG. 19 is a flowchart of a driving method of a display device according to a third embodiment of the present invention.

### DESCRIPTION OF THE EMBODIMENTS

In order to make the content of the present invention more easily understood, the following specific embodiments are provided as examples that the present invention can indeed be implemented accordingly. In addition, wherever possible, components/members/steps using the same reference numerals in the drawings and embodiments represent the same or similar parts. The term "substantially" in this specification and claims refers to a range of nominal value ±10% to ±20% after considering non-ideal factors such as parasitic effects, process variations, temperature effects, etc. of actual circuits, or those that can still achieve the same technical effect within this range.

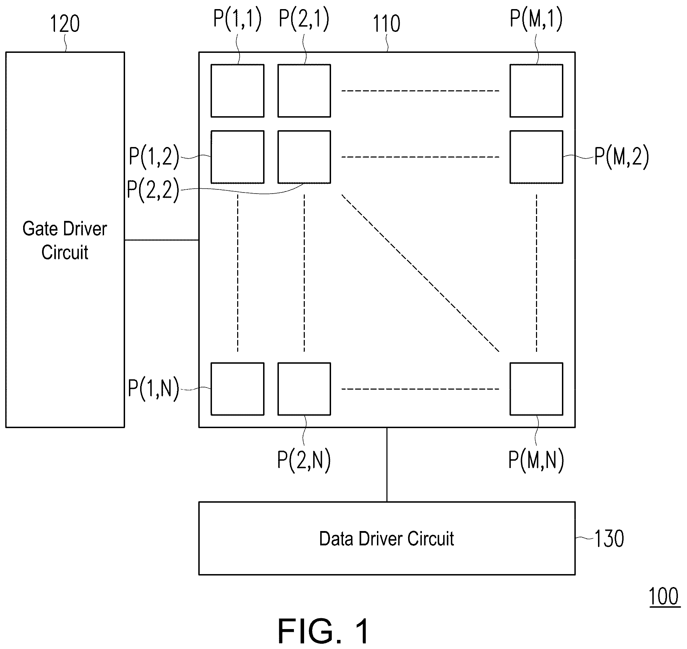

FIG. 1 is a schematic diagram of a display device according to an embodiment of the present invention. Referring to FIG. 1, the display device 100 includes a pixel array 110, a gate driver circuit 120, and a data driver circuit 130 (also referred to as a source driver circuit). The pixel array 110 is coupled to the gate driver circuit 120 and the data driver circuit 130. The pixel array 110 includes a plurality of pixel units P(1,1)~P(M,N), where M and N are positive integers. The gate driver circuit 120 may be coupled to the pixel units P(1,1)~P(M,N) through a plurality of gate signal lines. The data driver circuit 130 may be coupled to the pixel units P(1,1)~P(M,N) through a plurality of data signal lines (also referred to as source signal lines). Those applying this embodiment may operate the gate driver circuit 120 and the data driver circuit 130 independently according to their requirements, or may integrate the gate driver circuit 120 and the data driver circuit 130 into a single chip.

In one embodiment, the display device 100 may be a bistable display, such as an electrophoretic display (EPD) or a cholesteric liquid crystal (ChLCD) display. Those applying this embodiment may adjust the type of the display device 100 according to their requirements, as long as the pixel units in the display device 100 require high voltage driving, this embodiment may be applied. In one embodiment, the display device 100 is an electronic paper display. Each of the pixel units P(1,1)~P(M,N) may include a display component, such as a microcapsule, a microcup, or a liquid crystal unit.

In one embodiment, the pixel array 110 may be a thin film transistor (TFT) array. Each of the pixel units P(1,1)~P(M,N) includes a pixel circuit. The pixel circuit is formed on a glass substrate. The pixel circuit is used to generate voltage according to at least one gate drive signal and at least one data signal (also referred to as source drive signal) to drive a corresponding display component. In one embodiment, the gate driver circuit 120 includes a plurality of gate drivers, and the plurality of gate drivers are formed on the glass substrate in a gate on array (GOA) manner. The pixel array 110 and the gate driver circuit 120 may be formed on the same glass substrate. In one embodiment, the plurality of gate drivers may be respectively coupled to a plurality of pixel units in different rows.

Additionally, in the description of the following embodiments, the first terminal and the second terminal of the transistor may be a drain or a source respectively, and the control terminal of the transistor may be a gate, but the present invention is not limited thereto. The polarity of each terminal of the transistor may be determined according to different transistor types.

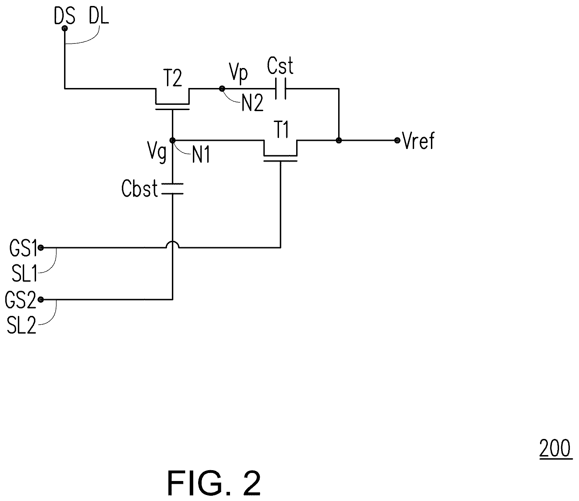

FIG. 2 is a schematic diagram of a pixel circuit according to an embodiment of the present invention. Referring to FIG. 2, in one embodiment, each of pixel units P(1,1)~P(M,N) of FIG. 1 may have the circuit architecture of the pixel circuit 200 as shown in FIG. 2. The pixel circuit 200 includes the bootstrap capacitor Cbst, the storage capacitor Cst, and the transistors T1~T2. The transistor T2 of this embodiment may be referred to as an active matrix switch. The pixel circuit 200 further includes a pixel capacitor (not shown), and the pixel capacitor may be coupled to node N2. The pixel capacitor is used to represent a display unit (e.g., microcapsule, cholesteric liquid crystal, liquid crystal unit, etc.) in the display device. The transistors T1~T2 of this embodiment are N-type transistors, but the present invention is not limited thereto. In other embodiments, the transistors T1~T2 may also be implemented as P-type transistors.

A first terminal of the transistor T1 is coupled to the node N1. A second terminal of the transistor T1 is coupled to the reference voltage terminal Vref. A control terminal of the transistor T1 is coupled to the gate signal line SL1. The reference voltage terminal Vref of this embodiment may be a common voltage terminal COM, and this common voltage terminal COM has a reference voltage of, for example, 0V.

A first terminal of the bootstrap capacitor Cbst is coupled to the node N1. A second terminal of the bootstrap capacitor Cbst is coupled to the gate signal line SL2. A control terminal of the transistor T2 is coupled to the node N1. A first terminal of the transistor T2 is coupled to the node N2. A second terminal of the transistor T2 is coupled to the data signal line DL to receive the data signal DS. A first terminal of the storage capacitor Cst is coupled to the node N2, and a second terminal of the storage capacitor Cst is coupled to the reference voltage terminal Vref. The pixel voltage Vp on the node N2 is used to represent the voltage on the first terminal of the storage capacitor Cst, and is also the voltage on one terminal of the pixel capacitor.

The gate signal line SL1 is used to transmit the gate drive signal GS1. The gate signal line SL2 is used to transmit the gate drive signal GS2. The gate signal line SL1 and the gate signal line SL2 are respectively used to transmit different gate drive signals GS1 and GS2. In this embodiment, the gate drive signals GS1 and GS2 may be provided by gate driver integrated circuits (e.g., the aforementioned multiple gate drivers) in the gate driver circuit 120.

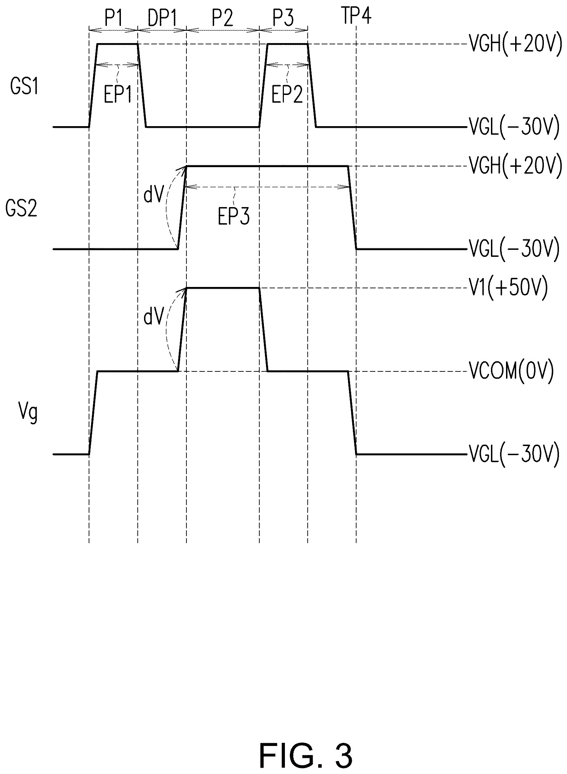

FIG. 3 is a timing diagram of multiple signals and voltages in the pixel circuit of FIG. 2. Referring to FIG. 2 and FIG. 3, the pixel circuit 200 may generate the gate voltage Vg located at the node N1 based on the operating method of the embodiment in FIG. 3. The gate signal line SL1 is used to transmit the gate drive signal GS1. The gate signal line SL2 is used to transmit the gate drive signal GS2. In this embodiment, the gate drive signal GS1 has the enable period EP1 and the enable period EP2, and the gate drive signal GS2 has the enable period EP3. The enable period EP1 and the enable period EP3 do not overlap, and the enable period EP2 is located within the enable period EP3. That is, the enable periods of the gate drive signals GS1 to GS2 respectively have partial overlap, as shown in the signal waveforms corresponding to the time period P3 in FIG. 3.

Referring to FIG. 2 and FIG. 3 simultaneously, during the enable period EP1 of the gate drive signal GS1 (that is, the time period P1 in FIG. 3), the gate drive signal GS1 switches from the low voltage level VGL (e.g., -30V) to the high voltage level VGH (e.g., +20V). Since the control terminal of the transistor T1 receives the gate drive signal GS1 at the high voltage level VGH (e.g., +20V), the transistor T1 is in the conduction state, and the gate voltage Vg at the node N1 is the reference voltage of the reference voltage terminal Vref (e.g., the common voltage VCOM of 0V). The control terminal of the transistor T2 is coupled to the gate drive signal GS2 at the low voltage level VGL (e.g., -30V), therefore the transistor T2 is in the turn-off state. The first terminal of the bootstrap capacitor Cbst (that is, the node N1) is at the common voltage VCOM of 0V, and the second terminal of the bootstrap capacitor Cbst is at the gate drive signal GS2 of the low voltage level VGL (e.g., -30V), therefore the bootstrap capacitor Cbst has a voltage difference of approximately 30V across its terminals.

During the disable period between the enable period EP1 of the gate drive signal GS1 and the enable period EP3 of the gate drive signal GS2 (that is, the time period DP1 in FIG. 3), the gate drive signal GS1 switches from the high voltage level VGH (+20V) to the low voltage level VGL (e.g., -30V), therefore both transistors T1 and T2 are in the turn-off state.

During the time period P2 which is within the enable period EP3 of the gate drive signal GS2 and before the enable period EP2 of the gate drive signal GS1, the transistor T1 is in the turn-off state, and the bootstrap capacitor Cbst has a voltage difference of approximately 30V across its terminals. When the gate drive signal GS2 switches from the low voltage level VGL (-30V) to the high voltage level VGH (+20V), the gate voltage Vg at the node N1 is boosted from the reference voltage (e.g., the common voltage VCOM) by the preset voltage value dV via the bootstrap capacitor Cbst. The preset voltage value dV is the voltage difference (e.g., +50V) between the low voltage level VGL (-30V) and the high voltage level VGH (+20V) of the gate drive signal GS2. Therefore, the gate voltage Vg at the node N1 will be boosted to the voltage V1 (e.g., +50V). During the time period P2, the transistor T2 is in the conduction state to guide the data signal DS on the second terminal of the transistor T2 to the node N2.

In one embodiment, the voltage range of the data signal DS is approximately -24 volts to +24 volts. Utilizing the gate voltage Vg (e.g., +50V) at the node N1 boosted via the bootstrap capacitor Cbst, the transistor T2 may completely write the data signal DS into the node N2, enabling the pixel voltage Vp to be charged to the range of -24 volts to +24 volts.

In one embodiment, the operating voltage range of the gate signal line SL1 is -30 volts to +20 volts. When the gate signal line SL2 switches from the low voltage level to the high voltage level, the gate voltage at the node N1 is boosted to approximately +50 volts via the bootstrap capacitor Cbst.

During the enable period EP2 of the gate drive signal GS1 (that is, the time period P3 in FIG. 3), the transistor T1 is in the conduction state and the transistor T2 is in the turn-off state, the gate voltage Vg at the node N1 is the reference voltage (the common voltage VCOM of 0V) based on the transistor T1 being in the conduction state.

At the disable time point TP4 after the enable period EP2 of the gate drive signal GS1 and the enable period EP3 of the gate drive signal GS2, the gate drive signal GS2 reduces from the high voltage level VGH to the low voltage level VGL, the gate voltage Vg at the node N1 reduces from the reference voltage (the common voltage VCOM of 0V) to the low voltage level VGL (-30V) via the bootstrap capacitor Cbst. Therefore, the active matrix switch (e.g., the transistor T2) may stably maintain its control terminal at the low voltage level when the data signal is not being written.

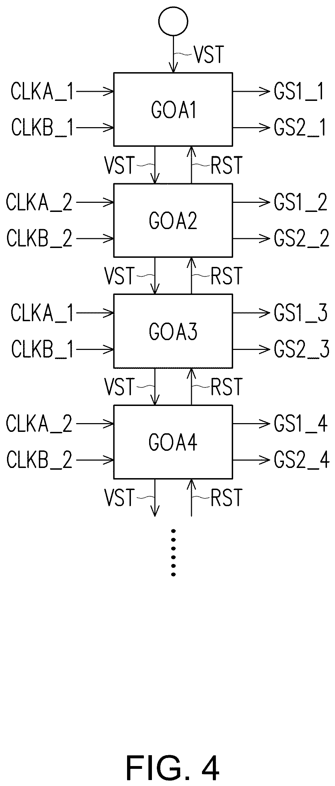

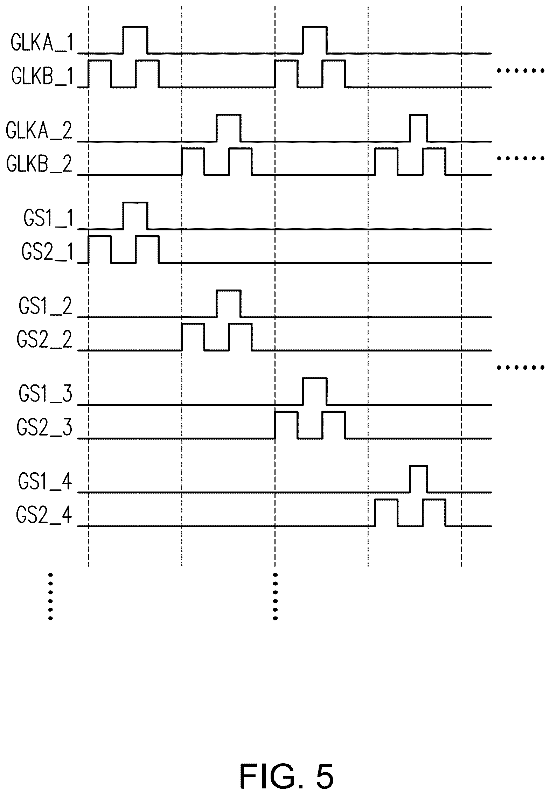

FIG. 4 is a detailed schematic diagram of a gate driver circuit in a display device according to an embodiment of the present invention. FIG. 5 is a schematic diagram of signals in the gate driver circuit of FIG. 4. Referring to FIG. 4 and FIG. 5 simultaneously, the gate driver circuit 120 of FIG. 1 may include a plurality of the gate drivers (e.g., the gate drivers GOA1~GOA4 in FIG. 4). This embodiment utilizes the setup signal VST and the reset signal RST to sequentially activate the gate drivers GOA1~GOA4. The activated gate drivers GOA1~GOA4 correspondingly generate the gate drive signals GS1_1~GS1_4 and GS2_1~GS2_4 based on the clock signals CLKA_1~CLKB_1 and CLKA_2~CLKB_2, and sequentially provide the gate drive signals GS1_1~GS1_4 and GS2_1~GS2_4 to pixel units of corresponding rows to implement the aforementioned pixel circuit 200 of FIG. 2.

The gate drive signals of the gate signal lines SL1 and SL2 are provided by a gate driver array circuit (e.g., the gate drivers GOA1~GOA4 in FIG. 4), each stage of the gate driver array circuit (e.g., each gate driver GOA1~GOA4) outputs at least two sets of gate drive signals. The gate driver array circuit receives a plurality of sets of clock signals (e.g., the clock signals CLKA_1~CLKB_1, CLKA_2~CLKB_2), and every two adjacent stages share at least one set of clock signals. For example, the gate driver GOA1 serves as one stage of the gate driver array circuit and outputs the gate drive signals GS1_1 and GS2_1 based on the clock signal CLKA_1 and clock signal CLKB_1; the gate driver GOA2 serves as one stage of the gate driver array circuit and outputs the gate drive signals GS1_2 and GS2_2 based on the clock signal CLKA_2 and the clock signal CLKB_2; the gate driver GOA3 serves as one stage of the gate driver array circuit and outputs the gate drive signals GS1_3 and GS2_3 based on the clock signal CLKA_1 and the clock signal CLKB_1; the gate driver GOA4 serves as one stage of the gate driver array circuit and outputs the gate drive signals GS1_4 and GS2_4 based on the clock signal CLKA_2 and the clock signal CLKB_2.

Referring to FIG. 5, each first gate signal line and second gate signal line (e.g., gate signal lines respectively comprising the gate signals GS1_1 and GS2_1, GS1_2 and GS2_2, GS1_3 and GS2_3, GS1_4 and GS2_4) are respectively dedicated control signal lines for pixel units of this row (e.g., first row, second row, third row, and fourth row), and may not simultaneously serve as gate signal lines for pixel units of adjacent rows. For example, the gate signal lines GS1_2 and GS2_2 are dedicated control signal lines for pixel units of the second row, and may not simultaneously serve as the gate signal lines for pixel units of the first row or third row.

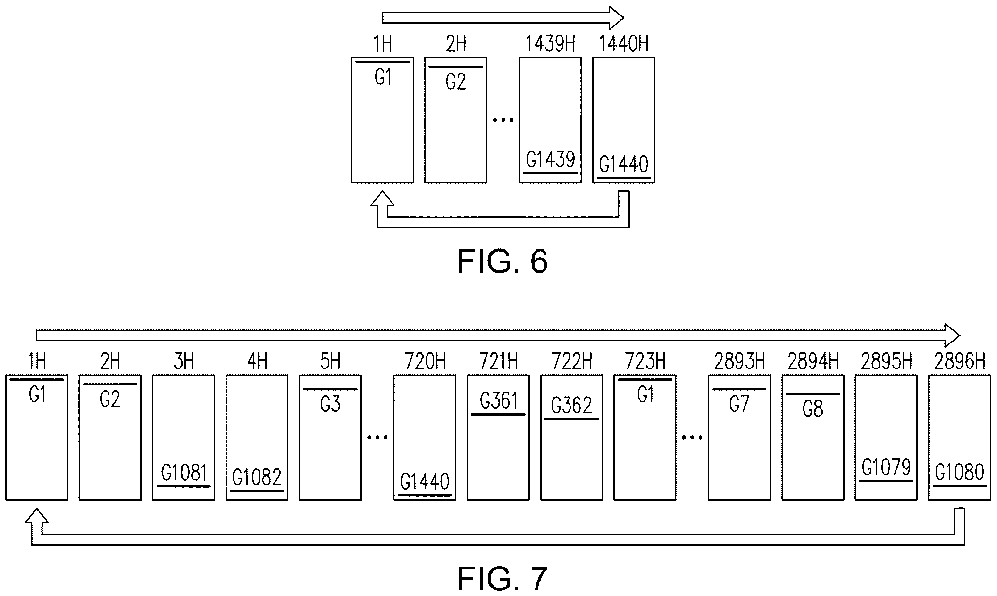

FIG. 6 and FIG. 7 are schematic diagrams of driving processes of each scan line in the display device of an embodiment of the present invention. Referring to FIG. 6, the pixel array of FIG. 1 may adopt sequential scanning, that is, during the time period 1H, the gate driver circuit 120 provides the gate drive signals (e.g., the gate drive signals GS1_1 and GS2_1 in FIG. 5) to multiple pixel units of the scan line G1 on the first row. During the time period 2H, the gate driver circuit 120 provides the gate drive signals (e.g., the gate drive signals GS1_2 and GS2_2 in FIG. 5) to multiple pixel units of the scan line G2 on the second row, and so on. Assuming that each frame in this embodiment has 1440 scan lines (that is, N equals 1440), during time period 1440H, the gate driver circuit 120 provides the gate drive signals (e.g., the gate drive signals GS1_N and GS2_N) to multiple pixel units of the scan line GN on the Nth row, and then the next time period returns to the time period 1H to sequentially scan each scan line.

Those applying this embodiment may also adopt different scanning methods for scan lines to reduce screen flicker. Referring to FIG. 7, the pixel array of FIG. 1 may adopt interlaced scanning across A scan lines. In detail, each pixel unit is divided into multiple groups of scan lines, and each group of scan lines includes one or more scan lines. One group of scan lines in this embodiment is 2 scan lines, that is, the scan lines G1~G2 are in the same group, the scan lines G7~G8 are in the same group, the scan lines G361~G362 are in the same group, the scan lines G1081~G1082 are in the same group, and the scan lines G1079~G1080 are in the same group.

The interlaced scanning across A scan lines includes the following steps. First, the X-th group of scan lines are scanned. Assuming X is 1, the 1-st group of the scan lines corresponds to the scan lines G1~G2. Therefore, during the time period 1H, the scan line G1 is scanned; during the time period 2H, the scan line G2 is scanned.

Then, after completing the scanning of the X-th group of scan lines, scan the (X+A)-th group of scan lines. A in this embodiment is 540, therefore, the 541-th group of scan lines will be scanned. During the time period 3H, the scan line G1081 is scanned; during the time period 4H, the scan line G1082 is scanned.

Next, after completing the scanning of the (X+A)-th group of scan lines, scan the (X+1)-th group of scan lines. X in this embodiment is 1, therefore, the 2-nd group of scan lines will be scanned. During the time period 5H, the scan line G3 in the 2-nd group of scan lines is scanned; during the time period 6H, the scan line G4 in the 2-nd group of scan lines is scanned. And so on, during the time period 720H, the scan line G1440 is scanned; during the time period 721H, the scan line G361 is scanned; during the time period 722H, the scan line G362 is scanned; during the time period 723H, the scan line G1 is scanned; during the time period 2893H, the scan line G7 is scanned; during the time period 2894H, the scan line G8 is scanned; during the time period 2895H, the scan line G1079 is scanned; during the time period 2896H, the scan line G1080 is scanned.

Those applying this embodiment may adjust the number of scan lines in each group in the interlaced scanning of FIG. 7 according to their needs, and may adjust the number of scan lines that need to be crossed (corresponding to 2A). The interlaced scanning described in this embodiment may reduce screen flicker when scanning the screen.

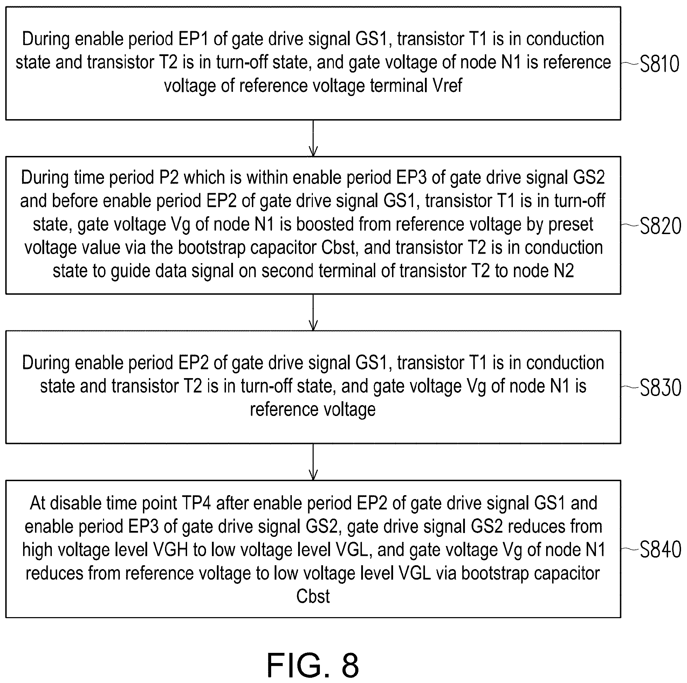

FIG. 8 is a flowchart of a driving method of a display device according to an embodiment of the present invention. The driving method of FIG. 8 is applicable to the display device 100 of FIG. 1 and the pixel circuit 200 of FIG. 2. The display device 100 includes a plurality of pixel units P(1,1)~P(M,N). Taking FIG. 2 as an example, each pixel unit includes the transistors T1~T2, the bootstrap capacitor Cbst, and the storage capacitor Cst. The first terminal of the transistor T1 is coupled to the node N1, the second terminal is coupled to the reference voltage terminal Vref, and the control terminal is coupled to the gate signal line SL1. The first terminal of the bootstrap capacitor Cbst is coupled to the node N1 and the second terminal is coupled to the gate signal line SL2. The control terminal of the transistor T2 is coupled to the node N1 and the first terminal thereof is coupled to the node N2. The storage capacitor Cst is coupled to the node N2. The gate drive signal GS1 is transmitted through the gate signal line SL1 and the gate drive signal GS2 is transmitted through the gate signal line SL2. The gate drive signal GS1 has the enable period EP1 and the enable period EP2, and the gate drive signal GS2 has the enable period EP3.

The driving method of FIG. 8 includes step S810 to step S840. Please refer to FIG. 3 and FIG. 8 simultaneously. In step S810, during the enable period EP1 of the gate drive signal GS1, the transistor T1 is in the conduction state and the transistor T2 is in the turn-off state, and the gate voltage of the node N1 is the reference voltage of the reference voltage terminal Vref.

In step S820, during the time period P2 which is within the enable period EP3 of the gate drive signal GS2 and before the enable period EP2 of the gate drive signal GS1, the transistor T1 is in the turn-off state, and the gate voltage Vg of the node N1 is boosted from the reference voltage by a preset voltage value via the bootstrap capacitor Cbst. Moreover, the transistor T2 is in the conduction state in step S820 to guide the data signal on the second terminal of the transistor T2 to the node N2.

In step S830, during the enable period EP2 of the gate drive signal GS1, the transistor T1 is in the conduction state and the transistor T2 is in the turn-off state, and the gate voltage Vg of the node N1 is the reference voltage.

In step S840, at the disable time point TP4 after the enable period EP2 of the gate drive signal GS1 and the enable period EP3 of the gate drive signal GS2, the gate drive signal GS2 reduces from the high voltage level VGH to the low voltage level VGL, and the gate voltage Vg of the node N1 reduces from the reference voltage to the low voltage level VGL via the bootstrap capacitor Cbst. For related details of each step in FIG. 8, please refer to the aforementioned embodiments.

In summary, the display device and driving method thereof of the embodiments of the present invention may utilize a circuit design with two transistors and one bootstrap capacitor disposed in the pixel circuit, and coordinate with different gate drive signals provided by two gate signal lines for control, so as to realize utilizing data voltage of lower voltage level to generate pixel voltage having higher voltage level. In detail, the display device of the embodiments of the present invention is based on the bootstrap capacitor of each pixel unit, and utilizes the gate drive signal (the gate voltage) between approximately -30 volt (V) to +20V to make the voltage of the control terminal reach -30V to +50V, thereby boosting the voltage of the control terminal in the active matrix switch (e.g., thin film transistor), effectively utilizing the boosted gate voltage to write the data signal into the display unit of the pixel circuit, enabling the display device to reduce cost without additionally disposing a driving system. In other words, the voltage specification of the gate driver integrated circuit may be reduced from the conventional approximately 80 volts to approximately 50 volts. Moreover, the active matrix switch (e.g., thin film transistor) of each pixel unit of the embodiments of the present invention may stably maintain its control terminal at the low voltage level when not writing the data signal, making each pixel unit have high stability. Furthermore, this embodiment may also combine with interlaced scanning to further reduce screen flickering.

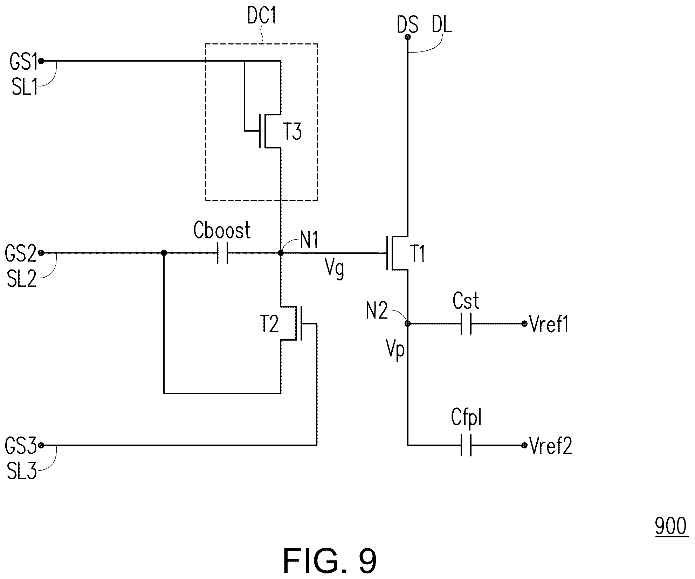

FIG. 9 is a schematic diagram of a pixel circuit according to a second embodiment of the present invention. Referring to FIG. 9, in one embodiment, each of the pixel units P(1,1)~P(M,N) in FIG. 1 may have the circuit architecture of the pixel circuit 900 as shown in FIG. 9. The pixel circuit 900 includes a bootstrap capacitor Cboost, a storage capacitor Cst, and transistors T1~T3. The pixel circuit 900 further includes a pixel capacitor Cfpl. The transistors T1~T3 in this embodiment are N-type transistors, but the present invention is not limited thereto. In other embodiments, the transistors T1~T3 may also be implemented with P-type transistors.

The first terminal of transistor T1 is coupled to data signal line DL to receive data signal DS. The control terminal of transistor T1 is coupled to the node N1. The second terminal of transistor T1 is coupled to node N2. One terminal of bootstrap capacitor Cboost is coupled to node N1. The other terminal of bootstrap capacitor Cboost is coupled to gate signal line SL2. One terminal of storage capacitor Cst is coupled to node N2, and the other terminal of storage capacitor Cst is coupled to reference voltage terminal Vref1. One terminal of pixel capacitor Cfpl is coupled to node N2, and the other terminal of pixel capacitor Cfpl is coupled to reference voltage terminal Vref2. The pixel capacitor Cfpl is used to represent a display unit (such as microcapsule, cholesteric liquid crystal, liquid crystal unit, etc.) in the display device.

The diode circuit DC1 is coupled to node N1. Specifically, the cathode terminal of diode circuit DC1 is coupled to node N1. The anode terminal of diode circuit DC1 is coupled to gate signal line SL1. The diode circuit DC1 in this embodiment includes transistor T3. The first terminal and control terminal of transistor T3 are coupled to gate signal line SL1. The second terminal of transistor T3 is coupled to node N1.

The transistor T2 is coupled to node N1. Specifically, the first terminal of the transistor T2 is coupled to node N1, and the second terminal of the transistor T2 is coupled to the gate signal line SL2. The control terminal of the transistor T2 is coupled to the gate signal line SL3. The gate signal line SL1, the gate signal line SL2, and the gate signal line SL3 are respectively used to transmit different gate drive signals GS1~GS3.

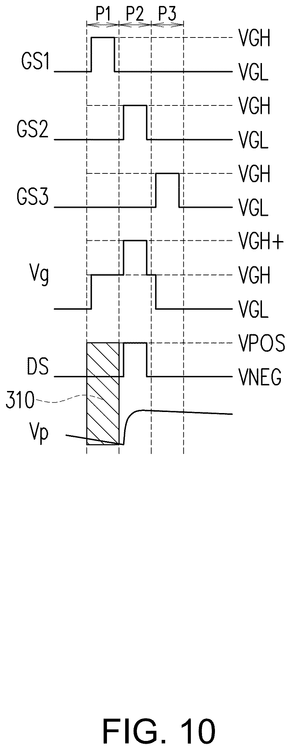

FIG. 10 is a timing diagram of multiple signals and voltages in the pixel circuit of FIG. 9. Referring to FIG. 9 and FIG. 10, the pixel circuit 900 may generate the pixel voltage Vp at the node N2 based on the operating method of the embodiment in FIG. 10. The gate signal line SL1 is used to transmit the gate drive signal GS1. The gate signal line SL2 is used to transmit the gate drive signal GS2. The gate signal line SL3 is used to transmit the gate drive signal GS3. In this embodiment, the pulse periods of the gate drive signals GS1~GS3 are non-overlapping.

During the time period P1, the gate drive signal GS1 switches to the high voltage level VGH, and the gate drive signals GS2~GS3 are at the low voltage level VGL, making the diode circuit DC1 conductive, the transistor T1 in the conduction state, and the transistor T2 in the turn-off state. In the time period P1, the transistor T1 is in the conduction state in response to the node N1 being at the high voltage level VGH, causing the pixel voltage Vp at the node N2 to be pre-charged (as shown in area 310). The diode circuit DC1 is conductive and the transistor T2 is operated in the turn-off state to enable the gate drive signal GS1 to boost the voltage Vg of the node N1 to the high voltage level VGH. At this time, the bootstrap capacitor Cboost will have a potential difference from the high voltage level VGH (the voltage Vg of the node N1) to the low voltage level VGL (the gate drive signal GS2).

During the time period P2, the gate drive signal GS2 switches to the high voltage level VGH, and the gate drive signals GS1, GS3 are at the low voltage level VGL, making the diode circuit DC1 turn off, the transistor T1 still in the conduction state, and the transistors T2~T3 operated in the turn-off state. Since the bootstrap capacitor Cboost has a potential difference from the high voltage level VGH (the voltage Vg of the node N1) to the low voltage level VGL (the gate drive signal GS2), when the gate drive signal GS2 switches from the low voltage level VGL to the high voltage level VGH, the voltage Vg at the node N1 located at the other terminal of the bootstrap capacitor Cboost is boosted again from the high voltage level VGH to the high voltage level VGH+.

Moreover, during the time period P2, the voltage on the data signal DS converts from the voltage VNEG to the voltage VPOS, therefore the transistor T1 transmits the voltage VPOS on the data signal DS to the pixel voltage Vp at the node N2, so that the charge on the data signal DS charges the node N2, causing the pixel voltage Vp to rise.

During the time period P3, the gate drive signal GS3 switches to the high voltage level VGH, and the gate drive signals GS1~GS2 are at the low voltage level VGL, making the diode circuit DC1 turn off, the transistor T1 in the turn-off state, and the transistor T2 in the conduction state. Based on the transistor T2 being in the conduction state, both terminals of the bootstrap capacitor Cboost receive the gate drive signal GS2 on the gate signal line SL2 and at the low voltage level VGL. In other words, both terminals of the bootstrap capacitor Cboost are coupled to the same potential, therefore the bootstrap capacitor Cboost does not have a potential difference between its terminals, making the voltage Vg at the node N1 all at the low voltage level VGL. The transistor T1 turns off to maintain the pixel voltage Vp at the node N2.

Therefore, this embodiment may utilize the circuit design of the bootstrap capacitor and three transistors provided in the pixel circuit 900 of FIG. 9, and coordinate with different gate drive signals provided by three gate signal lines for control, to utilize the bootstrap capacitor of each pixel unit (the pixel circuit 900) to boost the voltage at the control terminal in the active matrix switch (such as the transistor T1), thereby effectively utilizing the boosted gate voltage to write data signal into the display unit of the pixel circuit. Moreover, this embodiment may ensure that data signal can be accurately written through the aforementioned three-stage operation (such as the time periods P1~P3), and maintain the locking of the display data (such as the voltage at the node N2) during non-scan period.

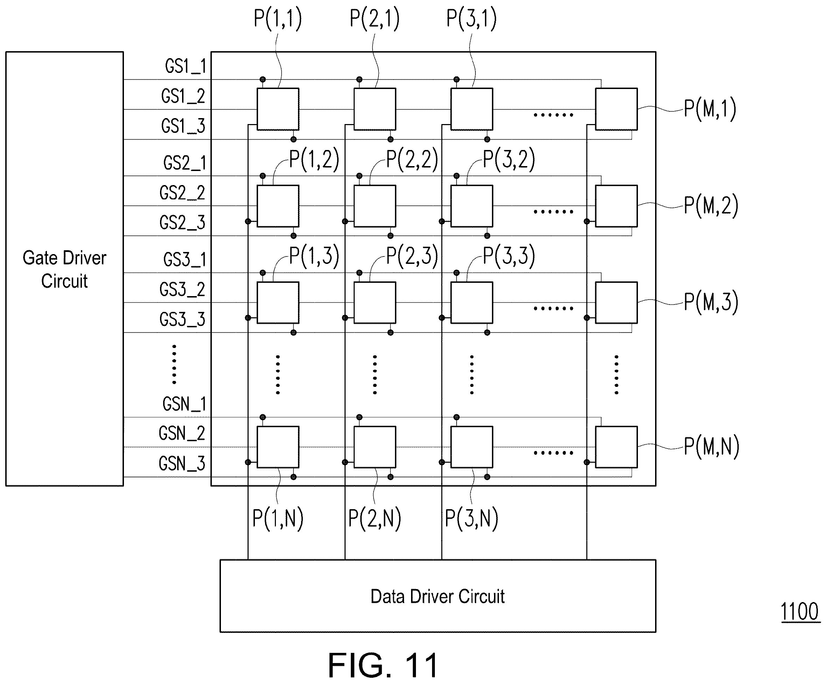

FIG. 11 is a schematic diagram of display device according a first sub embodiment in the second embodiment of the present invention. The main difference between FIG. 11 and FIG. 1 is that FIG. 11 separately illustrates each pixel unit and corresponding gate drive signals. For example, the pixel units P(1,1)~P(M,1) correspond to the gate drive signals GS1_1~GS1_3, the pixel units P(1,2)~P(M,2) correspond to the gate drive signals GS2_1~GS2_3, and so on, the pixel units P(1,N)~P(M,N) correspond to the gate drive signals GSN_1~GSN_3. This embodiment may design the pulse periods of these gate drive signals GSN_1~GSN_3 to be non-overlapping, but the gate drive signals between pixel units of different rows will not interfere with each other. What will interfere is only that the data signal line DL needs to provide corresponding data signal DS for pixel units of each row one by one.

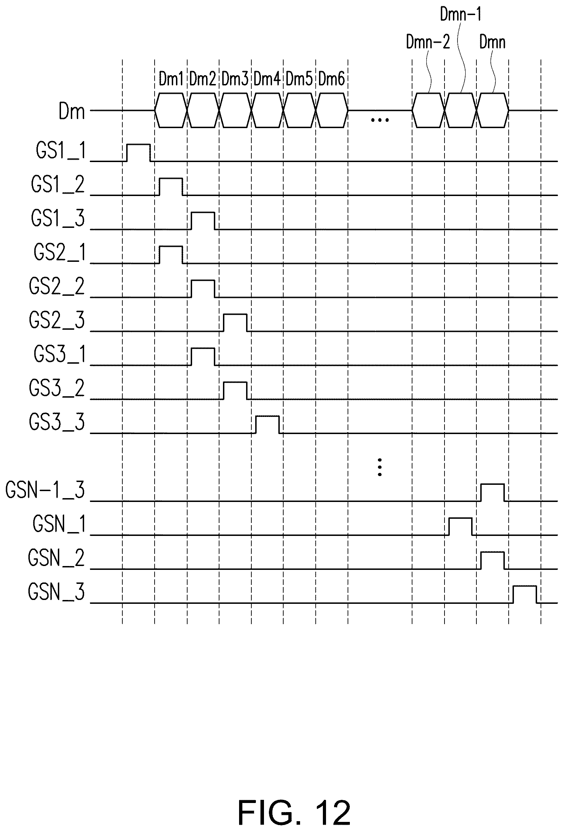

FIG. 12 is a schematic diagram of multiple signals in FIG. 11. FIG. 12 presents the operating period Dm of each gate drive signal GS1_1~GSN_3 and the data signal DS in FIG. 11. The operating period Dm of the data signal DS is used to represent the enable time of the data signal DS located in different rows. Please refer to FIG. 11 and FIG. 12 simultaneously. This embodiment saves operating time by making the gate drive signal (such as GS1_2) in pixel units of the X-th row (such as X being 1) (such as the pixel units P(1,1)~P(1,M)) equal to the gate drive signal (such as GS2_1) in the second pixel unit of the (X+1)-th row (such as X+1 being 2) (such as the pixel units P(2,1)~P(2,M)), and the gate drive signal (such as GS1_3) in pixel units of the X-th row (pixel units P(1,1)~P(1,M)) equal to the gate drive signal (such as GS2_2) in pixel units of the (X+1)-th row (the pixel units P(2,1)~P(2,M)). When the gate drive signal GS1_2 is enabled (such as the gate drive signal GS1_2 being at high voltage level), the operating period Dm1 will be used to provide the data signal DS to each pixel unit P(1,1)~P(1,M) of the 1-st row. When X is 2, the gate drive signal GS2_2 equals the gate drive signal GS3_1, and the gate drive signal GS2_3 equals the gate drive signal GS3_2. When the gate drive signal GS2_2 is enabled (such as the gate drive signal GS2_2 being at high voltage level), the operating period Dm2 will be used to provide data signal DS to each pixel unit P(2,1)~P(2,M) of the 2-nd row. And so on, when X is N-1, the gate drive signal GSN-1_2 equals the gate drive signal GSN_1, and the gate drive signal GSN-1_3 equals the gate drive signal GSN_2. When the gate drive signal GSN-1_2 is enabled (such as the gate drive signal GSN-1_2 being at high voltage level), the operating period Dmn-1 will be used to provide the data signal DS to each pixel unit P(N-1,1)~P(N-1,M) of the (N-1)-th row. The display device 1100 of FIG. 11 may overlap enable periods of partial gate drive signals to save overall operating time.

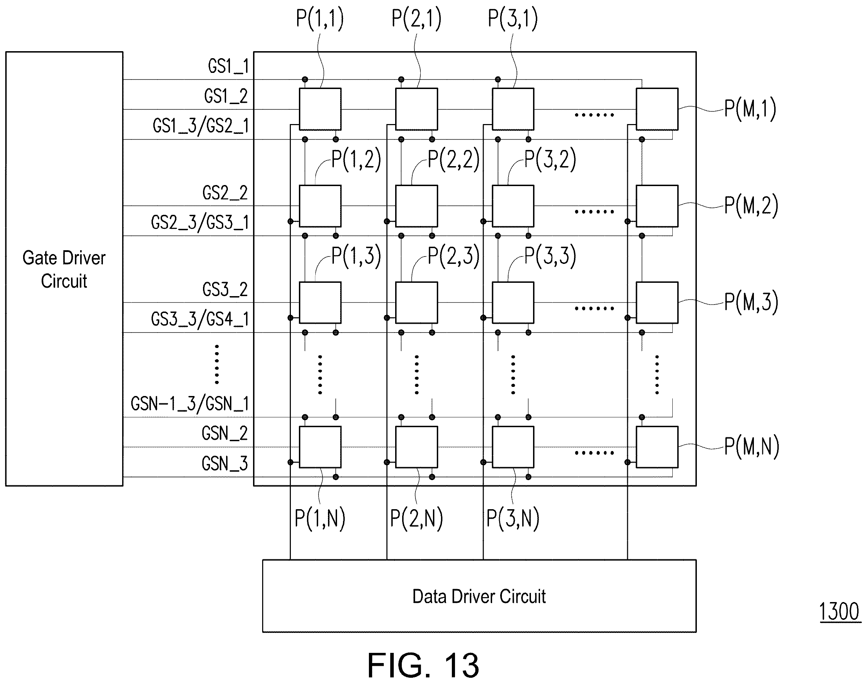

FIG. 13 is a schematic diagram of the display device according to a second sub embodiment in the second embodiment of the present invention. In this embodiment, the display device 1300 uses the gate signal line having the gate drive signal (such as GS1_3) in pixel units of the X-th row (such as X being 1) (such as the pixel units P(1,1)~P(1,M)) as the gate signal line having the gate drive signal (such as GS2_1) in pixel units of the (X+1)-th row (such as X+1 being 2) (such as the pixel units P(2,1)~P(2,M)), making the gate drive signal GS1_3 equal to the gate drive signal GS2_1. In this way, pixel units of the X-th row and the (X+1)-th row will share the gate signal line to obtain corresponding gate drive signals GS1_3 and GS2_1, thereby reducing the number of the gate signal lines.

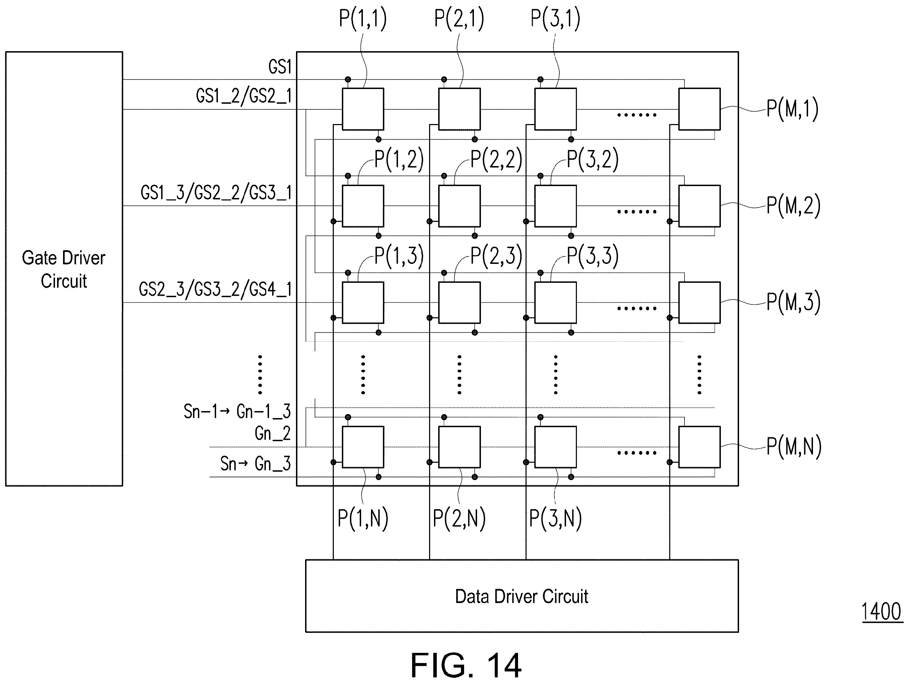

FIG. 14 is a schematic diagram of the display device according to a third sub embodiment in the second embodiment of the present invention. In this embodiment, the display device 1400 uses the gate signal line having the gate drive signal (such as GS1_3) in pixel units of the X-th row (such as X being 1) (such as the pixel units P(1,1)~P(1,M)) as the gate signal line having the gate drive signal (such as GS2_2) in pixel units of the (X+1)-th row (such as X+1 being 2) (such as the pixel units P(2,1)~P(2,M)), and as the gate signal line having the gate drive signal (such as GS3_1) in pixel units of the (X+2)-th row (such as X+2 being 3) (such as the pixel units P(3,1)~P(3,M)), making the gate drive signal GS1_3 equal to the gate drive signal GS2_2 and equal to the gate drive signal GS3_1. In this way, pixel units of the X-th row, the (X+1)-th row, and the (X+2)-th row will share the gate signal line to obtain corresponding gate drive signals GS1_3, GS2_2, and GS3_1, thereby reducing the number of the gate signal lines.

In one embodiment, the gate driver circuit of the display device in the above embodiments may also drive the pixel array in a reverse scan direction. Specifically, the gate driver circuit may sequentially scan from pixel units of the Nth row to pixel units of the 1-st row. Under the reverse scan direction, the operating principles of the bootstrap capacitor Cboost, the diode circuit DC1, and the transistor T2 in each pixel unit are the same as those in the aforementioned embodiments, that is, still sequentially executing the three-stage operation of the time period P1 (the boosting voltage Vg of the node N1 via the diode circuit DC1), the time period P2 (further boosting the voltage Vg of the node N1 via the capacitive coupling effect of the bootstrap capacitor Cboost to write the data signal DS), and the time period P3 (pulling down the voltage Vg of the node N1 via the transistor T2 to maintain the pixel voltage Vp). Under the reverse scan direction, pixel units of adjacent rows may still share the gate signal lines to reduce the total number of the gate signal lines. Moreover, the pixel unit structures of the aforementioned embodiments may be arranged in a horizontal mirror configuration to accommodate the gate signal line arrangement for the reverse scan direction.

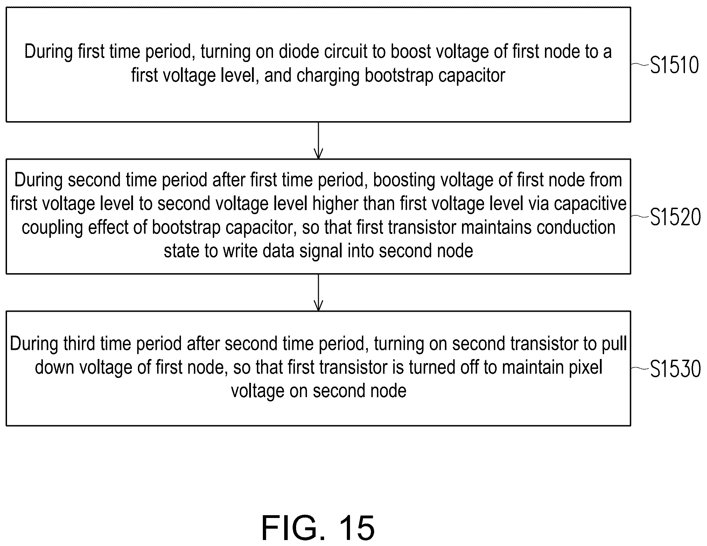

FIG. 15 is a flowchart of a driving method for a display device according to a second embodiment of the present invention. The driving method of FIG. 15 is applicable to the display device 100 of FIG. 1 and the pixel circuits 900 of FIG. 9. The display device 100 includes a plurality of pixel units P(1,1)~P(M,N). Taking FIG. 9 as an example, each pixel unit includes the transistor T1, the bootstrap capacitor Cboost, the diode circuit DC1, and the transistor T2. The control terminal of transistor T1 is coupled to the node N1. The bootstrap capacitor Cboost is coupled to the node N1. The diode circuit DC1 is coupled to the node N1. The transistor T2 is coupled to the node N1.

The driving method of FIG. 15 includes step S1510 to step S1530. Please refer to FIG. 10 and FIG. 15 simultaneously. In step S1510, during the time period P1, the diode circuit DC1 is turned on to boost the voltage of node N1 to a first voltage level (e.g., the high voltage level VGH), and the bootstrap capacitor Cboost is charged. In step S1520, during the time period P2 after the time period P1, the voltage of the node N1 is boosted from the first voltage level (the high voltage level VGH) to a second voltage level (e.g., the high voltage level VGH+) higher than the first voltage level via the capacitive coupling effect of the bootstrap capacitor Cboost, so that the transistor T1 maintains conduction state to write the data signal into the node N2. In step S1530, during the time period P3 after the time period P2, the transistor T2 is turned on to pull down the voltage Vg of the node N1, so that the transistor T1 is turned off to maintain the pixel voltage on the node N2. For related details of the aforementioned steps, please refer to the aforementioned embodiments.

In summary, the display device and driving method thereof according to the second embodiment of the present invention utilize the bootstrap capacitor of each pixel unit to boost the voltage of the control terminal in the active matrix switch (e.g., thin film transistor), thereby effectively utilizing the boosted gate voltage to write the data signal into the display unit of the pixel circuit. The gate driver circuit of this embodiment may operate in a low voltage environment, avoiding component damage or component characteristic drift caused by high voltage. If the active matrix switch located in the pixel unit of this embodiment is sufficiently resistant to high voltage, other components of the display device do not need to use high voltage resistant components. Each second embodiment of the present invention may also reduce the number of gate signal lines by sharing gate signal lines. Furthermore, the display device of each second embodiment of the present invention supports the forward scan direction and the reverse scan direction to enhance the flexibility of panel design. In addition, the present invention also proposes a corresponding driving method to implement the bootstrap boost function utilizing three-stage operating timing.

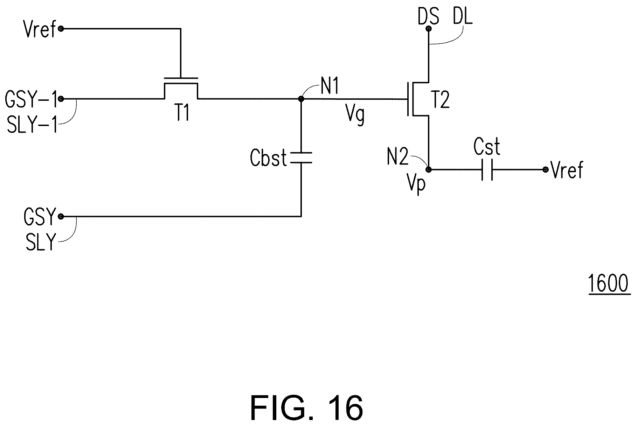

FIG. 16 is a schematic diagram of a pixel circuit of the third embodiment of the present invention. Referring to FIG. 16, in one embodiment, each of pixel units P(1,1)~P(M,N) of FIG. 1 may have the circuit architecture of the pixel circuit 1600 as shown in FIG. 16. The pixel circuit 1600 includes the bootstrap capacitor Cbst, the storage capacitor Cst, and the transistors T1~T2. The pixel circuit 1600 further includes a pixel capacitor (not shown), and the pixel capacitor may be coupled to the node N2. The pixel capacitor is used to represent a display unit (e.g., microcapsule, cholesteric liquid crystal, liquid crystal unit, etc.) in the display device. The transistors T1~T2 of this embodiment are N-type transistors, but the present invention is not limited thereto. In other embodiments, the transistors T1~T2 may also be implemented as P-type transistors.

The first terminal of the transistor T1 is coupled to the gate signal line SLY-1. The second terminal of the transistor T1 is coupled to the node N1. The control terminal of the transistor T1 is coupled to the reference voltage terminal Vref. The reference voltage terminal Vref of this embodiment may be the common voltage terminal COM, and this common voltage terminal COM has a reference voltage of, for example, 0V. The first terminal of the bootstrap capacitor Cbst is coupled to the gate signal line SLY. The second terminal of the bootstrap capacitor Cbst is coupled to the node N1. The first terminal of the transistor T2 is coupled to the data signal line DL to receive the data signal DS. The control terminal of the transistor T2 is coupled to the node N1. The second terminal of the transistor T2 is coupled to the node N2. One terminal of the storage capacitor Cst is coupled to node N2, and the other terminal of the storage capacitor Cst is coupled to the reference voltage terminal Vref.

The gate signal line SLY-1 and the gate signal line SLY are respectively used to transmit different gate drive signals GSY-1~GSY. Taking the pixel circuit in pixel unit P(X,Y) as an example, the gate drive signal GSY-1 of this embodiment is the gate drive signal in the pixel unit of the previous row (e.g., the Y-1-th row), and the gate drive signal GSY is the gate drive signal in the pixel unit of the current row (e.g., the Y-th row). In this embodiment, X and Y are both positive integers, X is greater than or equal to 1 and less than or equal to M, and Y is greater than or equal to 1 and less than or equal to N.

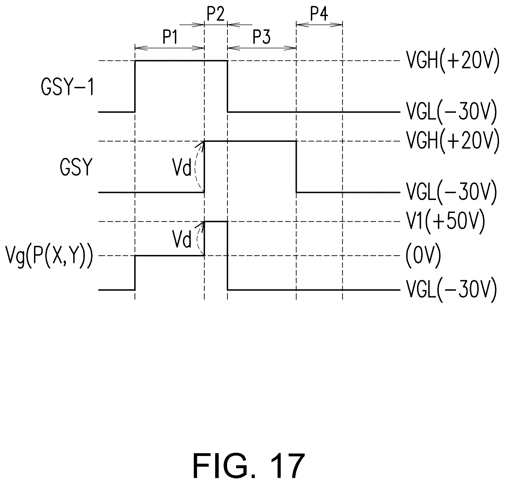

FIG. 17 is a timing diagram of multiple signals and voltages in the pixel circuit of FIG. 16. Referring to FIG. 16 and FIG. 17, the pixel circuit 1600 may generate the voltage Vg at the node N1 based on the operating method of the embodiment of FIG. 17. The gate signal line SLY-1 is used to transmit the gate drive signal GSY-1. The gate signal line SLY is used to transmit the gate drive signal GSY. In this embodiment, the pulse periods of the gate drive signals GSY-1~GSY respectively have partial overlap, as shown in the signal waveforms corresponding to the time period P2 in FIG. 17.

Referring to FIG. 16 and FIG. 17 simultaneously, in the time period P1 during the enable period of the gate drive signal GSY-1, the gate drive signal GSY-1 is boosted from the low voltage level VGL (e.g., -30 volts (V)) to the high voltage level VGH (e.g., +20V). Since the control terminal of the transistor T1 is coupled to the reference voltage terminal Vref such that the voltage at its control terminal is approximately the reference voltage (e.g., 0V), the transistor T1 is in the conduction state when its gate-source voltage difference is greater than the threshold voltage Vth, and the transistor T1 is in the turn-off state when its gate-source voltage difference is less than or equal to the threshold voltage Vth. When the gate drive signal GSY-1 is approximately 0V, since the gate-source voltage difference of the transistor T1 will be less than or equal to the threshold voltage Vth, the transistor T1 will switch from the conduction state to the turn-off state, therefore the voltage Vg at the second terminal of the transistor T1 (i.e., node N1) is approximately 0V. When the gate drive signal GSY-1 is greater than 0V, the transistor T1 is in the turn-off state, therefore the voltage Vg at the second terminal of transistor T1 (i.e., the node N1) will maintain at approximately 0V. That is, in the time period P1, the voltage Vg at the node N1 is boosted to close to the reference voltage (e.g., 0V). One terminal of the bootstrap capacitor Cbst receives the reference voltage (0V), and the other terminal of the bootstrap capacitor Cbst receives the gate drive signal GSY at the low voltage level VGL (-30V).

The time period P2 immediately follows the time period P1. In the time period P2 during the enable period of the gate drive signal GSY-1, the gate drive signal GSY-1 still maintains the high voltage level VGH (+20V), while the gate drive signal GSY is boosted from the low voltage level VGL to the high voltage level VGH. Therefore, the transistor T1 is in the turn-off state, and the voltage Vg at the node N1 is boosted from the reference voltage (0V) by the boost voltage value Vd (e.g., +50V) via the bootstrap capacitor Cbst to become the voltage V1 (e.g., +50V). The voltage value Vd is the voltage difference (+50V) between the low voltage level VGL (-30V) and the high voltage level VGH (+20V), causing the transistor T2 to switch from the turn-off state to the conduction state. Therefore, in the time period P2, the voltage on the data signal DS is transmitted to the pixel voltage Vp at the node N2 via the transistor T2 in the conduction state, such that the charge on the data signal DS charges the node N2, causing the pixel voltage Vp to rise.

In the time period P3 after the time period P2, the gate drive signal GSY-1 is reduced from the high voltage level VGH to the low voltage level VGL, the transistor T1 is in the conduction state, and the voltage Vg at the node N1 is reduced to the low voltage level VGL via the transistor T1 in the conduction state.

In the time period P4 after the time period P3, the gate drive signal GSY-1 and the gate drive signal GSY both maintain at the low voltage level VGL. Since the gate drive signal GSY-1 maintains at the low voltage level VGL, the transistor T1 maintains in the conduction state, and the voltage Vg at the node N1 is stably maintained at the low voltage level VGL via the transistor T1 in the conduction state. Therefore, in the time period P4, the voltage Vg at the control terminal (the node N1) of the transistor T2 is stably maintained at the low voltage level VGL, such that the transistor T2 maintains in the turn-off state, thereby ensuring that the pixel voltage may be stably maintained after the data write completion, avoiding leakage or interference of the pixel voltage. In other words, the time period P4 is a voltage stabilization period, and the transistor T1 performs voltage stabilization function during this period, stably maintaining voltage at the node N1 at the low voltage level VGL.

Therefore, this embodiment may utilize the circuit design with the bootstrap capacitor and two transistors of the pixel circuit 1600 in FIG. 16, and coordinate with gate drive signals provided by two gate signal lines for control, to utilize the bootstrap capacitor Cbst of each pixel unit (pixel circuit 1600) to boost the voltage at the control terminal of active matrix switch (e.g., transistor T2) from the voltage range of -30V to +20V to -30V to +50V, thereby utilizing a system with 50V voltage range to achieve the effect of 80V voltage range, effectively utilizing the boosted gate voltage to write the data signal into the display unit of the pixel circuit.

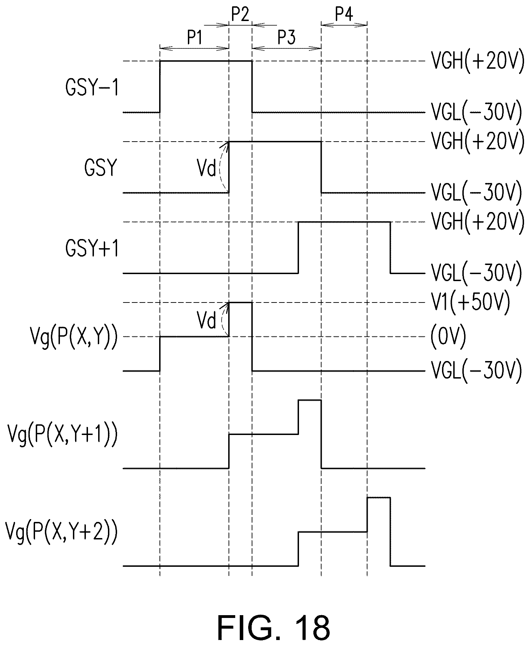

FIG. 18 is a timing diagram of multiple signals and voltages for adjacent rows of pixel units in the pixel circuit of FIG. 16. Here, the voltage Vg at the node N1 of each pixel circuit in pixel units P(X,Y), P(X,Y+1), and P(X,Y+2) is presented in FIG. 18, indicating that the first gate drive signal of the pixel circuit in the pixel unit P(X,Y) is the gate drive signal GSY-1 in the pixel unit located in the previous row (Y-1-th row), and the second gate drive signal is the gate drive signal GSY in the pixel unit located in the current row (Y-th row). The first gate drive signal of the pixel circuit in the pixel unit P(X,Y+1) is the gate drive signal GSY in the pixel unit located in the previous row (Y-th row), and the second gate drive signal is the gate drive signal GSY+1 in the pixel unit located in the current row (Y+1-th row), and so on. The gate drive signal GSY and the gate drive signal GSY-1 located in the previous row (Y-1-th row) have partial overlap in their enable periods (or pulse periods) during the time period P2.

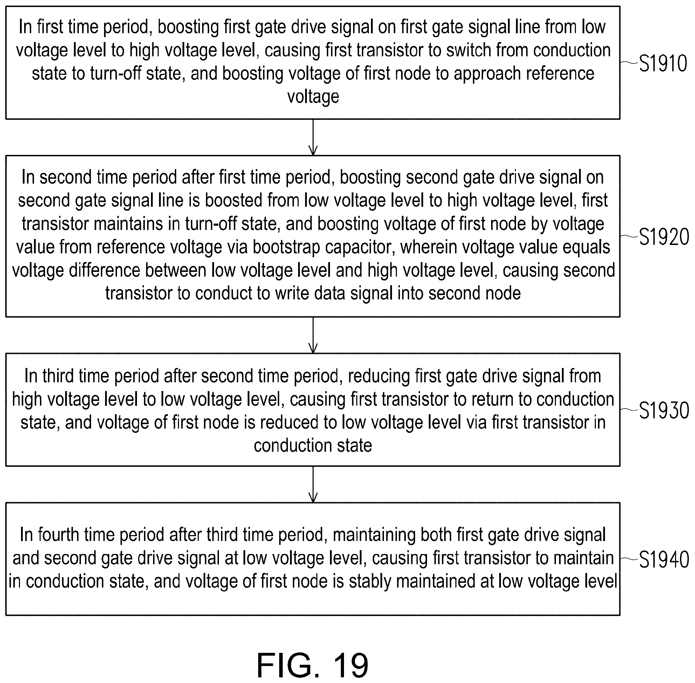

FIG. 19 is a flowchart of a driving method for a display device according to a third embodiment of the present invention. The driving method of FIG. 19 is applicable to the display device 100 of FIG. 1 and the pixel circuit 1600 of FIG. 16. The display device 100 includes multiple pixel units P(1,1)~P(M,N). Taking FIG. 16 as an example, each pixel unit includes the gate signal lines SLY-1 and SLY, the data signal line DL, the transistor T1, the bootstrap capacitor Cbst, the transistor T2, and the storage capacitor Cst. The first terminal of the transistor T1 is coupled to the gate signal line SLY-1 and the second terminal is coupled to the node N1. The first terminal of the bootstrap capacitor Cbst is coupled to the gate signal line SLY and the second terminal thereof is coupled to the node N1. The first terminal of the transistor T2 is coupled to the data signal line DL and the second terminal thereof is coupled to node N2. The control terminal of the transistor T2 is coupled to the node N1. The storage capacitor Cst is coupled to the node N2.

The driving method of FIG. 19 includes step S1910 to step S1940. Please refer to FIG. 17 and FIG. 19 simultaneously. In step S1910, in the time period P1, the gate drive signal GSY-1 on the gate signal line SLY-1 is boosted from the low voltage level VGL to the high voltage level VGH, causing the transistor T1 to switch from the conduction state to the turn-off state, and the voltage Vg of the node N1 is boosted to approach the reference voltage (e.g., 0V). In step S1920, in the time period P2 after the time period P1, the gate drive signal GSY on the gate signal line SLY is boosted from the low voltage level VGL to the high voltage level VGH, the transistor T1 maintains in the turn-off state, and the voltage Vg of the node N1 is boosted by a voltage value from the reference voltage via the bootstrap capacitor Cbst. This voltage value substantially equals the voltage difference Vd between the low voltage level VGL and the high voltage level VGH, causing the transistor T2 to conduct to write the data signal DS into the node N2. In step S1930, in the time period P3 after the time period P2, the gate drive signal GSY-1 is reduced from the high voltage level VGH to the low voltage level VGL, causing the transistor T1 to return to the conduction state, and the voltage Vg of the node N1 is reduced to the low voltage level VGL via the transistor T1 in the conduction state. In step S1940, in the time period P4 after the time period P3, both the gate drive signal GSY-1 and the gate drive signal GSY are maintained at the low voltage level VGL, causing the transistor T1 to maintain in the conduction state, and the voltage Vg of the node N1 is stably maintained at the low voltage level VGL.

In summary, the display device of the third embodiment of the present invention is based on the bootstrap capacitor of each pixel unit, and utilizes the gate drive signals (the gate voltage) between approximately -30V to +20V to make the voltage of the control terminal reach -30V to +50V, thereby boosting the voltage of the control terminal in the active matrix switch (e.g., thin film transistor), effectively utilizing the boosted gate voltage to write the data signals into the display unit of the pixel circuit, enabling the display device to reduce cost without requiring additional drive systems. Moreover, the display device described in the third embodiment of the present invention uses the same number of gate drive signals as conventional ones, and the control terminal in the active matrix switch (e.g., thin film transistor) of each pixel unit may stably maintain at low voltage level, making each pixel unit have high stability.

It is noting that in the above operations, the transistor T1 performs four functions respectively in different time periods: in the time period P1, the transistor T1 switches from the conduction state to the turn-off state, performing a preparation function, so that the voltage Vg of the node N1 is boosted to approach the reference voltage (e.g., the common voltage VCOM); in the time period P2, the transistor T1 maintains the turn-off state, performing an isolation function, the isolating node N1 from the reference voltage terminal, thereby enabling the capacitive coupling effect of the bootstrap capacitor to boost the voltage Vg of the node N1 to the voltage V1; in the time period P3, the transistor T1 returns to the conduction state, performing a release function, reducing the voltage Vg of the node N1 to the low voltage level VGL; in the time period P4, the transistor T1 maintains the conduction state, performing a voltage stabilization function, stably maintaining the voltage Vg of the node N1 at the low voltage level VGL. By utilizing a single transistor T1 to perform these four functions, a complete bootstrap operating cycle may be implemented without adding additional components, making the design of pixel circuit 1600 more concise and efficient.

## Claims

1. A display device (100), comprising:
a pixel array (110), comprising a plurality of pixel units (P(1,1)~P(M,N)),
wherein each of the plurality of pixel units (P(1,1)~P(M,N)) comprises:
a first transistor (T1), a first terminal of the first transistor (T1) coupled to a first node (N1), a second terminal of the first transistor (T1) is coupled to a reference voltage terminal (Vref), a control terminal of the first transistor (T1) is coupled to a first gate signal line (SL1), and the first gate signal line (SL1) is configured to transmit a first gate drive signal (GS1);
a bootstrap capacitor (Cbst), wherein a first terminal of the bootstrap capacitor (Cbst) is coupled to the first node (N1), a second terminal of the bootstrap capacitor (Cbst) is coupled to a second gate signal line (SL2), and the second gate signal line (SL2) is configured to transmit a second gate drive signal (GS1);
a second transistor (T2), wherein a control terminal of the second transistor (T2) is coupled to the first node (N1), a first terminal of the second transistor (T2) is coupled to a second node (N2), and a second terminal of the second transistor (T2) is coupled to a data signal line (DL) to receive a data signal (DS); and
a storage capacitor (Cst) coupled to the second node (N2), wherein a first terminal of the storage capacitor (Cst) is coupled to the second node (N2), and a second terminal of the storage capacitor (Cst) is coupled to the reference voltage terminal (Vref).

2. The display device as recited in claim 1, wherein the first gate drive signal (GS1) and the second gate drive signal (GS2) are different gate drive signals.

3. The display device as recited in claim 1, wherein the first gate drive signal (GS1) has a first enable period (EP1) and a second enable period (EP2), the second gate drive signal (GS2) has a third enable period (EP3), the first enable period (EP1) and the third enable period (EP3) do not overlap, and the second enable period (EP2) is located within the third enable period (EP3).

4. The display device as recited in claim 3, wherein during the first enable period (EP1) of the first gate drive signal (GS1), the first transistor (T1) is in a conduction state and the second transistor (T2) is in a turn-off state, and a gate voltage (Vg) at the first node (N1) is a reference voltage (VCOM) of the reference voltage terminal (Vref).

5. The display device as recited in claim 4, wherein during a second period (P2) located within the third enable period (EP3) of the second gate drive signal (GS2) and before the second enable period (EP2) of the first gate drive signal (GS1), the first transistor (T1) is in the turn-off state, and the gate voltage (Vg) at the first node (N1) is boosted from the reference voltage (VCOM) by a preset voltage value (dV) via the bootstrap capacitor (Cbst), wherein the preset voltage value (dV) substantially equals a voltage difference between a low voltage level (VGL) and a high voltage level (VGH) of the second gate drive signal (GS2).

6. The display device as recited in claim 5, wherein during the second time period (P2), the second transistor (T2) is in the conduction state to guide the data signal (DS) on the second terminal of the second transistor (T2) to the second node (N2).

7. The display device as recited in claim 5, wherein during the second enable period (EP2) of the first gate drive signal (GS1), the first transistor (T1) is in the conduction state and the second transistor (T2) is in the turn-off state, and the gate voltage (Vg) of the first node (N1) is the reference voltage (VCOM).

8. The display device as recited in claim 7, wherein at a disable time point (TP4) after the second enable period (EP2) of the first gate drive signal (GS1) and the third enable period (EP3) of the second gate drive signal (GS2), the second gate drive signal (GS2) is reduced from the high voltage level (VGH) to the low voltage level (VGL), and the gate voltage at the first node (N1) is reduced from the reference voltage (VCOM) to the low voltage level (VGL) via the bootstrap capacitor (Cbst).

9. The display device as recited in claim 1, wherein the pixel array (110) adopts an interlaced scanning across A scan lines,
wherein the pixel units (P(1,1)~P(M,N)) are divided into a plurality of groups of scan lines (G1~G2, G1081~G1082, G361~G362, G7~G8, G1079, G1080), and each group of scan lines (G1~G2, G1081~G1082, G361~G362, G7~G8, G1079, G1080) includes one or more scan lines (G1~G1080), and
the interlaced scanning across A scan lines comprises:
scanning an X-th group of scan lines (G1~G2);
scanning an (X+A)-th group of scan lines (G1081~G1082) after the X-th group of scan lines (G1~G2) is scanned; and
scanning an (X+1)-th group of scan lines (G3~G4) after the (X+A)-th group of scan lines (G1081~G1082) is scanned.

10. The display device as recited in claim 1, wherein the first transistor (T1) and the second transistor (T2) are N-type transistors.

11. The display device as recited in claim 1, wherein the display device (100) is a bistable display.

12. The display device as recited in claim 1, wherein an operating voltage range of the first gate signal line (GS1) is -30 volts to +20 volts, and when the second gate signal line (GS2) is switched from a low voltage level (VGL) to a high voltage level (VGH), a gate voltage (Vg) at the first node (N1) is boosted to approximately +50 volts via the bootstrap capacitor (Cbst).

13. The display device as recited in claim 12, wherein the display device reduces a voltage specification requirement of a gate driver integrated circuit (120, GOA1~GOA4) to approximately 50 volts.

14. The display device as recited in claim 1, wherein gate drive signals of the first gate signal line (GS1) and the second gate signal line (GS2) are provided by a gate driver integrated circuit (120, GOA1~GOA4).

15. The display device as recited in claim 1, wherein gate drive signals of the first gate signal line (GS1) and the second gate signal line (GS2) are provided by a gate driver array circuit (GOA1~GOA4), and each stage of the gate driver array circuit (GOA1~GOA4) outputs at least two sets of gate drive signals (GS1_1, GS2_1; GS1_2, GS2_2; GS1_3, GS2_3; GS1_4, GS2_4).

16. The display device as recited in claim 15, wherein the gate driver array circuit receives a plurality of sets of clock signals (CLKA_1, CLKA_2), and every two adjacent stages share at least one set of the clock signals(CLKA_1, CLKA_2).

17. The display device as recited in claim 1, wherein the first gate signal line (SL1) and the second gate signal line (SL2) are dedicated control signal lines for the pixel units (P(1,1)~P(M,N)), and do not simultaneously serve as gate signal lines for pixel units (P(1,1)~P(M,N)) of adjacent rows.

18. A driving method of a display device, wherein the display device comprises a plurality of pixel units (P(1,1)~P(M,N)), each of the pixel units (P(1,1)~P(M,N)) comprises a first transistor (T1), a bootstrap capacitor (Cbst), a second transistor (T2), and a storage capacitor (Cst), a first terminal of the first transistor (T1) is coupled to a first node (N1), a second terminal of the first transistor (T1) is coupled to a reference voltage terminal (Vref), and a control terminal of the first transistor (T1) is coupled to a first gate signal line (SL1), a first terminal of the bootstrap capacitor (Cbst) is coupled to the first node (N1) and a second terminal of the bootstrap capacitor (Cbst) is coupled to a second gate signal line (SL2), a control terminal of the second transistor (T2) is coupled to the first node (N1) and a first terminal of the second transistor (T2) is coupled to a second node (N2), and the storage capacitor (Cst) is coupled to the second node (N2), wherein a first gate drive signal (GS1) is transmitted through the first gate signal line (SL1) and a second gate drive signal (GS2) is transmitted through the second gate signal line (SL2), the first gate drive signal (GS1) has a first enable period (EP1) and a second enable period (EP2), and the second gate drive signal (GS2) has a third enable period (EP3),
the driving method comprising:
(S810) during the first enable period (EP1) of the first gate drive signal (GS1), the first transistor (T1) is in a conduction state and the second transistor (T2) is in a turn-off state, and a gate voltage at the first node (N1) is a reference voltage (VCOM) of the reference voltage terminal (Vref);
(S820) during a second period (P2) located within the third enable period (EP3) of the second gate drive signal (GS2) and before the second enable period (EP2) of the first gate drive signal (GS1), the first transistor (T1) is in the turn-off state, and the gate voltage (Vg) at the first node (N1) is boosted from the reference voltage (VCOM) by a preset voltage value (dV) via the bootstrap capacitor (Cbst), wherein the preset voltage value (dV) substantially equals a voltage difference between a low voltage level (VGL) and a high voltage level (VGH) of the second gate drive signal (GS2), and, the second transistor (T2) is in the conduction state to guide a data signal (DS) on the second terminal of the second transistor (T2) to the second node (N2);
during the second enable period (EP2) of the first gate drive signal (GS1), the first transistor (T1) is in the conduction state and the second transistor (T2) is in the turn-off state, and the gate voltage (Vg) of the first node (N1) is the reference voltage (VCOM); and
at a disable time point (TP4) after the second enable period (EP2) of the first gate drive signal (GS1) and the third enable period (EP3) of the second gate drive signal (GS2), the second gate drive signal (GS2) is reduced from the high voltage level (VGH) to the low voltage level (VGL), and the gate voltage (Vg) at the first node (N1) is reduced from the reference voltage (VCOM) to the low voltage level (VGL) via the bootstrap capacitor (Cbst).

19. The driving method as recited in claim 18, wherein during the second period (T2), a voltage range of the data signal (DS) guided to the second node (N2) via the second transistor (T2) is approximately -24 volts to +24 volts.

20. The driving method as recited in claim 18, wherein the high voltage level (VGH) of the first gate drive signal (GS1) is approximately +20 volts, the low voltage level (VGL) of the first gate drive signal (GS1) is approximately -30 volts, the gate voltage (Vg) of the first node (N1) after being stepped up is approximately +50 volts, and the gate voltage (Vg) of the first node (N1) after being pulled down is approximately -30 volts.
